# EUROPEAN PATENT SPECIFICATION

(11) **EP 3 904 825 B1**
(45) Date of publication and mention of the grant of the patent: **15.03.2023**
(21) Application number: 19906318.1
(22) Date of filing: 20.12.2019
(51) Int. Cl.: H01L 21/66, G01B 11/24, G01B 11/255, B24B 9/14, B24B 49/04, B24B 49/12

(54) **SEMICONDUCTOR WAFER EVALUATION METHOD AND SEMICONDUCTOR WAFER PRODUCTION METHOD**
VERFAHREN ZUR BEURTEILUNG EINES HALBLEITERWAFERS UND VERFAHREN ZUR HERSTELLUNG EINES HALBLEITERWAFERS
PROCÉDÉ D'ÉVALUATION DE TRANCHE DE SEMI-CONDUCTEUR ET PROCÉDÉ DE PRODUCTION DE TRANCHE DE SEMI-CONDUCTEUR

(30) Priority: 27.12.2018 JP 2018245438
(43) Date of publication of application: 03.11.2021
(73) Proprietor: SUMCO CORPORATION, Minato-ku, Tokyo 105-8634 (JP)
(72) Inventor: NISHIMURA Masashi, Tokyo 105-8634 (JP); TANAKA Hironori, Tokyo 105-8634 (JP)
(74) Representative: Godemeyer Blum Lenze Patentanwälte Partnerschaft mbB - werkpatent
(86) International application number: PCT/JP2019/049970
(87) International publication number: WO 2020/137837

(56) References cited:
- JP-A- 2009 300 287
- JP-A- 2011 095 214
- JP-A- 2016 130 738
- JP-A- 2018 056 351
- US-A1- 2011 207 246

## Description

### [Technical Field]

The present invention relates to a semiconductor wafer evaluation method and a semiconductor wafer manufacturing method.

### [Background Art]

In recent years, the shape of the outer peripheral edge of a wafer has been evaluated for a semiconductor wafer (hereinafter, also simply referred to as "wafer") (see, for example, PTL 1 and PTL 2).

### [Citation List]

### [Patent Literature]

[PTL 1] Japanese Patent Application Publication No. 2016-130738
[PTL 2] US 2011/207246 A1

### [Summary of Invention]

### [Technical Problem]

A semiconductor wafer is generally manufactured by subjecting a wafer, cut out from an ingot, to various processes. Since the outer peripheral edge of the wafer cut out from the ingot has corners unless being modified, cracks and chips are likely to occur therein. Therefore, at least an outer peripheral edge portion of one of the surface (front surface) side of the semiconductor wafer, which is the device forming surface side, and the surface (back surface) side opposite to the front surface is usually chamfered to obtain a chamfered surface. PTL 1 proposes to acquire an image of this chamfered surface so that the chamfered surface is displayed in white and calculate the width dimension of the chamfered surface from the width dimension in this image (see PTL 1, paragraphs [0060] to [0062]). In the following, unless otherwise specified, the "surface" of a semiconductor wafer means either one or both of the front surface and the back surface.

With regard to the surface of the semiconductor wafer, the main surface on the front surface side is a plane on which a device is to be formed, and the plane on the back side thereof is the main surface on the back surface side. The chamfered surface formed on the outer peripheral edge of the wafer has a surface shape inclined with respect to the adjacent main surfaces. Therefore, when looking at the cross-sectional shape in the thickness direction of the semiconductor wafer, the shape changes significantly at the boundary between the main surface and the chamfered surface adjacent to the main surface. The shape of the boundary portion between the main surface and the chamfered surface can serve as an index for predicting the susceptibility to dust generation, chipping, and scratches in a semiconductor device manufacturing process. For example, in a semiconductor device manufacturing process, the front surface of a wafer is a position where a resist or other process film is to be formed, and also a position in contact with an edge grip of a semiconductor device manufacturing apparatus. Therefore, by appropriately setting the shape of the boundary portion contiguous with the chamfered surface, it is possible to prevent dust generation caused by film peeling due to contact, and also to prevent the occurrence of chipping and scratches caused by contact per se. Further, by appropriately setting the shape of the boundary portion between the chamfered surface and the back surface of the wafer according to the shape of a wafer support that supports the wafer, it is possible to prevent the occurrence of contact-induced chips and scratches on the boundary portion. By suppressing the occurrence of chips and scratches, the occurrence rate of dislocations (slip) caused thereby can also be reduced. However, the method described in PTL 1 is a method for obtaining the width dimension of the chamfered surface, and the method described in PTL 1 cannot evaluate the shape of the boundary portion between the chamfered surface and the main surface.

One aspect of the present invention aims at providing a new method for evaluating the shape of a boundary portion between a chamfered surface and a main surface of a semiconductor wafer.

### [Solution to Problem]

During diligent studies, the present inventors focused their attention on a reflection type differential interference microscope. With the reflection type differential interference microscope, it is possible to obtain a differential interference image in which the contrast corresponding to a height difference on a sample surface to be evaluated is represented by using the interference of reflected light from the sample surface. The contrast represented in the differential interference image obtained with the reflection type differential interference microscope shows black, white or gray interference color in a flat portion, depending on the setting of the reflection type differential interference microscope, and can be optionally adjusted so that a portion lower and a portion higher than the flat portion show interference colors different from that of the flat portion. As a result of diligent studies, the present inventors have newly found that in a case where a reflection type differential interference microscope is set so that a main surface which is a flat portion in a semiconductor wafer having a chamfered surface shows a gray interference color, and a portion lower than the flat portion shows a black interference color, and a differential interference image is acquired by observing an outer peripheral portion of the semiconductor wafer, a white band appears between a gray band and a black band in the acquired differential interference image. Furthermore, the present inventors have newly found that the width of this white band can be used as an index for evaluating the shape of a boundary portion between the main surface and the chamfered surface of the outer peripheral portion.

That is, one aspect of the present invention relates to
a semiconductor wafer evaluation method including:
acquiring a differential interference image at an evaluation position on an outer peripheral portion of a semiconductor wafer to be evaluated with a reflection type differential interference microscope that is set so that a main surface of the semiconductor wafer is imaged as a gray band and a chamfered surface thereof is imaged as a black band, the differential interference image including the gray band and the black band, and further including a white band between the gray band and the black band; and
evaluating a shape of a boundary portion between the main surface of the semiconductor wafer and the chamfered surface adjacent to the main surface at the evaluation position by using a width W of the white band as an indicator.

Regarding the width W of the white band, the present inventors have found that the gentler the shape of the boundary between the main surface and the chamfered surface, the larger the value of W, and the steeper the shape of the boundary between the main surface and the chamfered surface, the smaller the value of W. Therefore, based on this value of W, it is possible to evaluate the gentleness/steepness of the shape of the boundary portion between the main surface and the chamfered surface.

One aspect of the present invention relates to
a semiconductor wafer manufacturing method including:
manufacturing a candidate semiconductor wafer to be shipped as a product,
evaluating the candidate semiconductor wafer by the above semiconductor wafer evaluation method; and
subjecting a semiconductor wafer, which has been determined to be a non-defective product as a result of the evaluation, to preparation for shipment as a product semiconductor wafer.

One aspect of the present invention relates to
a semiconductor wafer manufacturing method including:
manufacturing a semiconductor wafer lot including a plurality of semiconductor wafers;
extracting at least one semiconductor wafer from the semiconductor wafer lot;
evaluating the extracted semiconductor wafer by the above semiconductor wafer evaluation method; and
subjecting a semiconductor wafer of the same semiconductor wafer lot as the semiconductor wafer, which has been determined to be a non-defective product as a result of the evaluation, to preparation for shipment as a product semiconductor wafer.

One aspect of the present invention relates to
a semiconductor wafer manufacturing method including:
manufacturing a semiconductor wafer to be evaluated under a test manufacturing condition;
evaluating the manufactured semiconductor wafer to be evaluated by the above semiconductor wafer evaluation method;
determining a manufacturing condition, obtained by modifying the test manufacturing condition on the basis of a result of the evaluation, as an actual manufacturing condition, or determining the test manufacturing condition as the actual manufacturing condition; and
manufacturing a semiconductor wafer under the determined actual manufacturing condition.

In one aspect, the modified manufacturing condition may be at least one of a polishing treatment condition and a chamfering processing condition of a semiconductor wafer surface.

### [Effects of Invention]

According to one aspect of the present invention, it is possible to provide a new method for evaluating the shape of a boundary portion between a chamfered surface and a main surface of a semiconductor wafer.

### [Brief Description of Drawings]

[Fig. 1]

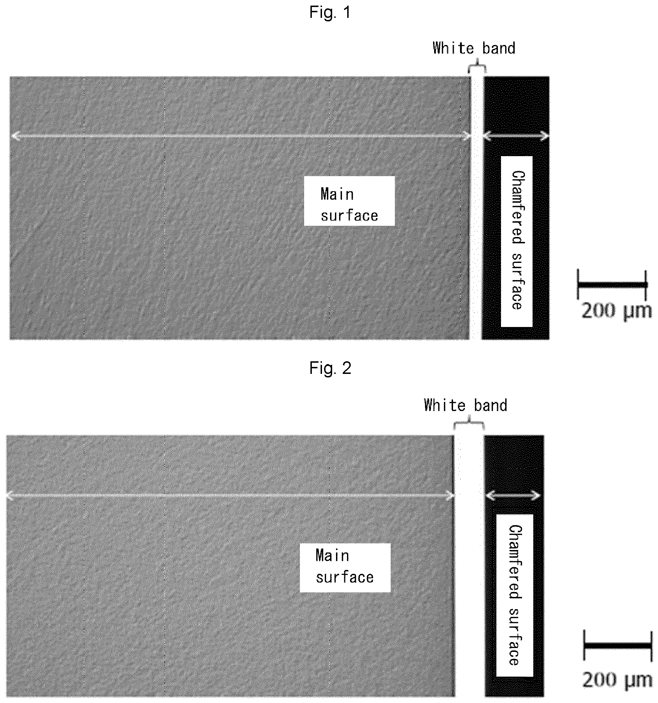

   Fig. 1 shows a differential interference image (wafer 1) obtained in Example.
[Fig. 2]
   Fig. 2 shows a differential interference image (wafer 2) obtained in Example.
[Fig. 3]

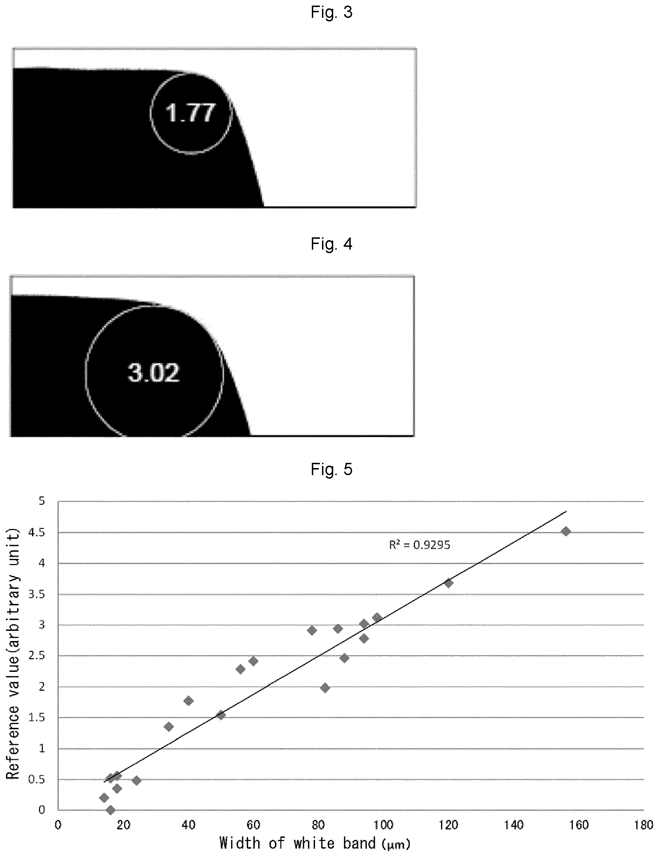

   Fig. 3 shows a binarized image (wafer 1) obtained by an evaluation method for obtaining a reference value.
[Fig. 4]
   Fig. 4 shows a binarized image (wafer 2) obtained by an evaluation method for obtaining a reference value.
[Fig. 5]
   Fig. 5 shows a graph showing a correlation between an evaluation result obtained by the semiconductor wafer evaluation method according to one aspect of the present invention and a reference value.

### [Description of Embodiments]

### [Semiconductor Wafer Evaluation Method]

One aspect of the present invention relates to a semiconductor wafer evaluation method (hereinafter, also simply referred to as "evaluation method") including:
acquiring a differential interference image at an evaluation position on an outer peripheral portion of a semiconductor wafer to be evaluated with a reflection type differential interference microscope that is set so that a main surface of the semiconductor wafer is imaged as a gray band and a chamfered surface thereof is imaged as a black band, the differential interference image including the gray band and the black band, and further including a white band between the gray band and the black band; and
evaluating a shape of a boundary portion between the main surface of the semiconductor wafer and the chamfered surface adjacent to the main surface at the evaluation position (hereinafter, also simply referred to as "boundary portion") by using a width W of the white band as an indicator.

The above evaluation method will be described hereinbelow in more detail.

### <Semiconductor Wafer to Be Evaluated>

The above evaluation method includes evaluating the shape of a boundary portion between the main surface of the semiconductor wafer to be evaluated and the chamfered surface adjacent to the main surface. Therefore, the semiconductor wafer to be evaluated is a semiconductor wafer having a chamfered surface, that is, a semiconductor wafer in which a chamfered surface has been formed by chamfering the outer peripheral edge portion of the wafer. The semiconductor wafer to be evaluated can be of various types of semiconductor wafers generally used as semiconductor substrates. For example, various silicon wafers can be mentioned as specific examples of semiconductor wafers. The silicon wafer can be, for example, a silicon single crystal wafer that has been cut out from a silicon single crystal ingot and then subjected to various processing such as chamfering. A specific example of such a silicon single crystal wafer is a polished wafer that has been polished and has a polished surface on its surface. Further, a silicon wafer can be of various types such as an epitaxial wafer having an epitaxial layer on a silicon single crystal wafer, an annealed wafer in which a modified layer is formed in a silicon single crystal wafer by annealing, and the like.

### <Acquisition of Differential Interference Image and Shape Evaluation of Boundary Portion>

The above evaluation method includes acquiring a differential interference image at an evaluation position on the outer peripheral portion of the semiconductor wafer to be evaluated by a reflection type differential interference microscope. In the present invention and the present description, the "outer peripheral portion" means a region including an outer peripheral edge portion on which a chamfered surface is formed and an outer peripheral region of the main surface adjacent to the chamfered surface. Therefore, the differential interference image obtained by capturing the image of the evaluation position of the outer peripheral portion with a reflection type differential interference microscope includes the main surface (specifically, the outer peripheral region of the main surface) and the chamfered surface adjacent to the main surface. As the reflection type differential interference microscope, a commercially available reflection type differential interference microscope or a reflection type differential interference microscope having a known configuration can be used without any limitation. A well-known configuration of the reflection type differential interference microscope described in, for example, Japanese Patent Application Publication No. 2009-300287 (Fig. 1 and paragraphs [0020] to [0025]) can be adopted. In a reflectiontype differential interference microscope, where light emitted from a light source is polarized and passed through a Nomarski prism, two rays (ordinary ray and abnormal ray) with orthogonal polarization directions are obtained. The type of light emitted from the light source is not limited, and can be light of any wavelength, may be monochromatic light, and may include light in a wavelength range having a predetermined width. The above two rays are radiated onto a sample as two parallel rays separated by a specific distance by using an objective lens. By adjusting the optical distance between the normal ray and the abnormal ray passing through the Nomarski prism by the position where the Nomarski prism is installed, the position of the zeroth order of interference can be arbitrarily controlled, and thereby the interference color of the zeroth order of interference (flat surface) can be adjusted. In addition, by adjusting the separation direction (called "shear direction") between the normal ray and the abnormal ray with the Nomarski prism, the interference color of a portion lower/higher than the position of the zeroth order of interference (flat surface) can be adjusted. In the above evaluation method, the reflection type differential interference microscope is set so that the main surface at the zeroth order position of interference is imaged as a gray band and the chamfered surface which is lower than the main surface is imaged as a black band. The difference in tint of the differential interference image obtained by the reflection type differential interference microscope depends on the difference in brightness, and the black band is a band with the brightness lower than that of the gray band.

In the course of repeated studies, the present inventors have found that where a differential interference image is acquired at an evaluation position on an outer peripheral portion of a semiconductor wafer to be evaluated by using a reflection type differential interference microscope that has been set as described hereinabove, a differential interference image is obtained in which a white band having a higher brightness than the gray band corresponding to the main surface and the black band corresponding to the chamfered surface can be confirmed between these two bands. As a result of further diligent studies, regarding the width W of the white band, it was newly found that the gentler the shape of the boundary between the main surface and the chamfered surface, the larger the value of W, and the steeper the shape of the boundary between the main surface and the chamfered surface, the smaller the value of W. Therefore, based on this value of W, it is possible to evaluate the shape of the boundary portion between the main surface and the chamfered surface. More specifically, the degree of gentleness (in other words, the degree of steepness) of the shape of the boundary portion between the main surface and the chamfered surface can be evaluated. From the viewpoint of reliability of evaluation, it is preferable that the shape of the boundary portion could be evaluated using the value of W in this way because the evaluation can be objectively performed based on the numerical value. In the present invention and the present description, the difference in tint (brightness) of the bands on the differential interference image (that is, whether the tint is gray, black, or white), in one aspect, can be a difference in tin (brightness) recognizable by the human eye, and in another aspect, can be determined by known image processing by setting a brightness threshold for each band.

The evaluation position of the above evaluation can be an arbitrary position on the outer peripheral portion of the semiconductor wafer to be evaluated. In one aspect, the semiconductor wafer to be evaluated has a notch. Regarding a semiconductor wafer with a notch, where the notch position (the tip of the notch) is set at 6 o'clock, the position opposite to the notch position on the outer periphery of the wafer is set at 12 o'clock, and each position on the outer periphery of the wafer is specified clockwise, the evaluation position can be any position from the 0 o'clock position (matches the 12 o'clock position) to the 12 o'clock position clockwise. There may be one evaluation position or may be a plurality of evaluation positions of two or more.

As described above, according to the above evaluation method, the shape of the boundary portion between the main surface and the chamfered surface adjacent to the main surface can be evaluated on the wafer surface (front surface or back surface) of a semiconductor wafer.

Further, the above evaluation method can be carried out without requiring that a sample piece be cut out (for example, cleaved) from the semiconductor wafer to be evaluated. That is, according to the above evaluation method, non-destructive evaluation is possible. This is preferable from the viewpoint of enabling simple evaluation. This is also preferable from the viewpoint of ease of shape evaluation of the boundary portion at a plurality of different locations of the same semiconductor wafer. For example, according to one aspect, the above evaluation method can include acquiring a differential interference image at each of a plurality of positions on the outer peripheral portion of the semiconductor wafer to be evaluated, and obtaining the W at a plurality of different positions on the outer peripheral portion of the semiconductor wafer to be evaluated. The shape of the boundary portion at each position can be evaluated based on each of the plurality of Ws thus obtained. In addition, the representative value (for example, an average value (for example, an arithmetic mean), a minimum value, a maximum value, and the like) of a plurality of W values obtained by evaluation at different positions of the same semiconductor wafer can be used as an index for shape evaluation of the boundary portion of the semiconductor wafer.

### [Semiconductor Wafer Manufacturing method]

A semiconductor wafer manufacturing method according to one aspect of the present invention (first manufacturing method) includes:
manufacturing a candidate semiconductor wafer to be shipped as a product,
evaluating the candidate semiconductor wafer by the above semiconductor wafer evaluation method, and
subjecting a semiconductor wafer, which has been determined to be a non-defective product as a result of the evaluation, to preparation for shipment as a product semiconductor wafer.

A semiconductor wafer manufacturing method according to another aspect of the present invention (second manufacturing method) includes:
manufacturing a semiconductor wafer lot including a plurality of semiconductor wafers;
extracting at least one semiconductor wafer from the semiconductor wafer lot;
evaluating the extracted semiconductor wafer by the above semiconductor wafer evaluation method; and
subjecting a semiconductor wafer of the same semiconductor wafer lot as the semiconductor wafer, which has been determined to be a non-defective product as a result of the evaluation, to preparation for shipment as a product semiconductor wafer.

A semiconductor wafer manufacturing method according to another aspect of the present invention (third manufacturing method) includes:
manufacturing a semiconductor wafer to be evaluated under a test manufacturing condition;
evaluating the manufactured semiconductor wafer to be evaluated by the above semiconductor wafer evaluation method;
determining a manufacturing condition, obtained by modifying the test manufacturing condition on the basis of a result of the evaluation as an actual manufacturing condition, or determining the test manufacturing condition, as the actual manufacturing condition; and
manufacturing a semiconductor wafer under the determined actual manufacturing condition.

In the first manufacturing method, the evaluation is carried out by the above evaluation method as a so-called pre-shipment inspection. Further, in the second manufacturing method, the semiconductor wafer of the same lot as the semiconductor wafer determined as a non-defective product as a result of so-called sampling inspection is prepared for shipping as a product semiconductor wafer. In the third manufacturing method, the semiconductor wafer manufactured under the test manufacturing condition is evaluated, and the actual manufacturing condition is determined based on the evaluation result. In any of the first manufacturing method, the second manufacturing method, and the third manufacturing method, the evaluation of the semiconductor wafer is performed by the evaluation method according to one aspect of the present invention described above.

### <First Manufacturing method>

In the first manufacturing method, the candidate semiconductor wafer to be shipped as a product can be manufactured in the same manner as in the general semiconductor wafer manufacturing method. For example, a polished wafer, which is an embodiment of a silicon wafer, can be manufactured by manufacturing steps including cutting (slicing) a silicon wafer from a silicon single crystal ingot grown by a Czochralski method (CZ method) or the like, chamfering, roughly polishing (for example, lapping), etching, mirror polishing (finish polishing), and cleaning performed during or after the abovementioned processing steps. Further, an annealed wafer can be manufactured by subjecting the polished wafer manufactured as described above to an annealing treatment. An epitaxial wafer can be manufactured by vapor-phase growing (epitaxial growth) an epitaxial layer on the surface of the polished wafer manufactured as described above.

In the manufactured semiconductor wafer, the shape of the boundary portion between the main surface and the chamfered surface adjacent to the main surface is evaluated by the evaluation method according to one aspect of the present invention. The details of the evaluation method are as described above. Then, the semiconductor wafer determined to be a non-defective product as a result of the evaluation is prepared for shipment as a product semiconductor wafer. The criteria for determining a non-defective product can be determined according to the quality required for the product semiconductor wafer. For example, in one aspect, whether the obtained W is equal to or greater than a certain value (that is, equal to or greater than a threshold value), equal to or less than a threshold value, or within a certain range can be used as a criterion for determining a non-defective product. Further, a representative value of W (for example, an average value (for example, an arithmetic mean), a minimum value, a maximum value, and the like) obtained by evaluation at different positions of the same semiconductor wafer can be also used as the W to be taken as an index. The same also applies to the second manufacturing method and the third manufacturing method. Preparation for shipping as a product semiconductor wafer can include, for example, packaging. In this way, according to the first manufacturing method, it is possible to stably supply to the market a semiconductor wafer in which the shape of the boundary portion between the main surface and the chamfered surface is the shape desired for the product semiconductor wafer.

### <Second Manufacturing method>

Manufacturing of a semiconductor wafer lot in the second manufacturing method can also be performed in the same manner as in the general semiconductor wafer manufacturing method, for example, as described above for the first manufacturing method. The total number of semiconductor wafers included in the semiconductor wafer lot is not particularly limited. The number of semiconductor wafers extracted from the manufactured semiconductor wafer lot and subjected to so-called sampling inspection is at least one, and may be two or more, and the number is not particularly limited.

For the semiconductor wafer extracted from the semiconductor wafer lot, the shape of the boundary portion between the main surface and the chamfered surface adjacent to the main surface is evaluated by the evaluation method according to one aspect of the present invention. The details of the evaluation method are as described above. Then, the semiconductor wafer of the same semiconductor wafer lot as the semiconductor wafer determined to be a non-defective product as a result of the evaluation is prepared for shipment as a product semiconductor wafer. The criteria for determining a non-defective product can be determined according to the quality required for the product semiconductor wafer. For example, in one aspect, whether the obtained W is equal to or greater than a certain value (that is, equal to or greater than a threshold value) can be used as a criterion for determining a non-defective product. The preparation for shipping as a product semiconductor wafer is, for example, as described above for the first manufacturing method. According to the second manufacturing method, it is possible to stably supply to the market semiconductor wafers in which the shape of the boundary portion between the main surface and the chamfered surface is the shape desired for the product semiconductor wafer. Further, since the evaluation method according to one aspect of the present invention enables non-destructive evaluation, in one aspect of the second manufacturing method, even the semiconductor wafer extracted from the semiconductor wafer lot and subjected to the evaluation can be prepared for shipment as a product semiconductor wafer and shipped as a product semiconductor wafer after the preparation, provided that the wafer has been determined to be a non-defective product as a result of the evaluation.

### <Third Manufacturing method>

Regarding the third manufacturing method, various conditions in various processes for manufacturing a semiconductor wafer can be mentioned as conditions included in the test manufacturing condition and the actual manufacturing condition. The various processes for manufacturing a semiconductor wafer are as described above for the first manufacturing method. The "actual manufacturing condition" is assumed to mean the manufacturing condition of a product semiconductor wafer.

In the third manufacturing method, the test manufacturing condition is set and a semiconductor wafer to be evaluated is manufactured under the test manufacturing condition as a preliminary step for determining the actual manufacturing condition. In the manufactured semiconductor wafer, the shape of the boundary portion between the main surface and the chamfered surface adjacent to the main surface is evaluated by the evaluation method according to one aspect of the present invention. The details of the evaluation method are as described above. The number of semiconductor wafers to be evaluated is at least one, and may be two or more, and the number thereof is not particularly limited. Where the evaluation result indicates that the shape of the boundary portion of the semiconductor wafer to be evaluated is the shape desired for the product semiconductor wafer, the product semiconductor wafer is manufactured and shipped using the test manufacturing condition as the actual manufacturing condition, whereby the product semiconductor wafer having a desired shape can be stably supplied to the market. Meanwhile, where the evaluation result indicates that the shape of the boundary portion of the semiconductor wafer to be evaluated is different from the shape desired for the product semiconductor wafer, the manufacturing condition obtained by changing the test manufacturing condition is determined as the actual manufacturing condition. The manufacturing condition to be changed is preferably a manufacturing condition that is considered to affect the shape of the boundary portion. As an example of such a manufacturing condition, polishing conditions for the surface (front surface and/or back surface) of the semiconductor wafer can be mentioned. Specific examples of such polishing conditions include rough polishing conditions and mirror polishing conditions. More specifically, the type of polishing liquid, the abrasive grain concentration of the polishing liquid, the type of polishing pad (for example, hardness, etc.) and the like can be mentioned. In addition, as an example of the manufacturing condition, chamfering conditions can be mentioned, specifically, machining conditions such as grinding and polishing in chamfering can be mentioned, and more specifically, the type of polishing tape used for chamfering can be mentioned. By determining the manufacturing condition obtained by changing the test manufacturing condition as the actual manufacturing condition, manufacturing the product semiconductor wafer under the actual manufacturing condition and shipping the manufactured wafer, it is possible to stably supply the product semiconductor wafer having the desired boundary shape to the market. The process of manufacturing the semiconductor wafer to be evaluated again under the manufacturing condition obtained by changing the test manufacturing condition, evaluating the semiconductor wafer to be evaluated by the evaluation method according to one aspect of the present invention, and determining whether the manufacturing condition is to be used as the actual manufacturing condition or has to be further changed may be performed once or repeated two or more times.

Regarding a method for determining whether or not the shape of the boundary portion of the semiconductor wafer to be evaluated is the shape desired for the product semiconductor wafer in the above-described third manufacturing method, it is possible to refer to the descriptions relating to the determination of non-defective products in the first manufacturing method and the second manufacturing method hereinabove.

Regarding other details of the first manufacturing method, the second manufacturing method, and the third manufacturing method, known techniques relating to the manufacturing method of semiconductor wafers can be adopted.

### [Examples]

Hereinafter, the present invention will be further described based on Examples. However, the present invention is not limited to the aspects shown in Examples.

### 1. Evaluation of Semiconductor Wafer

Two types of semiconductor wafers with different polishing conditions and chamfering conditions on the wafer surface (silicon single crystal wafers (polished wafers) with a diameter of 300 mm and a (100) surface, with a notch) were prepared. Hereinafter, one semiconductor wafer is referred to as "wafer 1", and the other semiconductor wafer is referred to as "wafer 2". Using a reflection type differential interference microscope (MX-50 made by Olympus Corporation), images of the wafer 1 and the wafer 2 were captured at a 3 o'clock position specified as described above by using the notch position as a reference (6 o'clock position), and differential interference images were acquired. The reflection type differential interference microscope was used for the imaging after setting so that the main surface was imaged as a gray band and the chamfered surface was imaged as a black band.

Fig. 1 shows the differential interference image obtained for the wafer 1, and Fig. 2 shows the differential interference image obtained for the wafer 2. In Figs. 1 and 2, a gray band corresponding to the main surface and a black band corresponding to the chamfered surface can be confirmed, and a white band can be confirmed between the two bands. The width of the white band in Fig. 1 (hereinafter referred to as "W1 ") was 40 µm, and the width of the white band in Fig. 2 (hereinafter referred to as "W2") was 95 µm.

From the above results, it was determined that the wafer 2 having a wider white band has a gentler shape of the boundary portion than the wafer 1.

In the above evaluation, the determination was made based on the specific numerical value of the width of the white band, but the shape of the boundary portion may be also evaluated based on the difference in the width of the white band that can be visually confirmed and recognized by the differential interference image, rather than based on the specific numerical value. For example, where Figs. 1 and 2 are compared, the white band in Fig. 2 is clearly wider than the white band in Fig. 1. Based on this result, it can be also determined that the shape of the boundary portion of the wafer 2 is gentler than that of the wafer 1.

### 2. Acquisition of Reference Value and Comparison between Evaluation Result of 1. Hereinabove and Reference Value

The fact that the width W of the white band obtained in the evaluation method according to one aspect of the present invention is a value that can be an index of the shape of the boundary portion can be confirmed by, for example, a good correlation between a reference value acquired by the following evaluation method and W obtained by the evaluation method according to one aspect of the present invention.

First, a cross-sectional image of the semiconductor wafer including the boundary to be evaluated is obtained. The cross-sectional image can be acquired, for example, by imaging, with a microscope, a cross-section of a semiconductor wafer that has been cleaved on a cleavage plane and exposed.

An enlarged image of the acquired cross-sectional image enlarged only in the wafer thickness direction is created. By enlarging only in the wafer thickness direction, the shape of the boundary portion can be emphasized with respect to the main surface (so-called horizontal plane) in the contour of the cross-sectional shape. Therefore, by using the enlarged image, it is possible to evaluate the gentleness/steepness of the boundary more accurately than by using the cross-sectional image that has not been enlarged. Further, by binarizing the enlarged image, the outline of the cross-sectional shape can be displayed more clearly, so that the gentleness/steepness of the boundary portion can be evaluated more accurately.

In the contour of the wafer cross-sectional shape in the binarized image obtained in this way, the shape of the boundary portion between the main surface and the chamfered surface is usually curved. Therefore, on this contour, a circle having an arc shape that approximates or matches the shape of this curve is fitted to the shape of the curve of the boundary portion between the main surface and the chamfered surface. It can be determined that the larger the size of the circle (curvature circle) thus obtained, for example, the larger the diameter or radius of the circle, the gentler the shape of the boundary portion, and it can be determined that the smaller the size of the circle, the steeper the shape of the boundary portion.

Therefore, in order to acquire the reference value, the two types of semiconductor wafers evaluated in 1. hereinabove were cleaved on the (110) plane to prepare samples for cross-section observation.

The same reflection type differential interference microscope as above was used and brightness and contrast of the prepared cross-sectional observation sample were adjusted to acquire a cross-sectional image (imaging magnification: 500 times) including the boundary between the main surface and the chamfered surface.

The acquired cross-sectional image was imported into image processing software (software name Photoshop CS5 manufactured by Adobe Inc.), enlarged 10 times only in the wafer thickness direction, and then binarized.

The binarized image obtained by performing the above binarization process was imported into software (PowerPoint made by Microsoft Corporation), and using a graphic drawing tool of the software, a circle with a circular arc shape substantially matching the shape of the curve was drawn on the contour of the cross-sectional shape. It was visually determined that the shape of the curve and the shape of the arc were substantially the same. Fig. 3 shows a binarized image of the wafer 1 obtained by the above method (an image obtained by binarizing after enlarging 10 times only in the wafer thickness direction). Fig. 4 shows a binarized image of the wafer 2 obtained by the above method (an image obtained by binarizing after enlarging 10 times only in the wafer thickness direction). Figs. 3 and 4 also show a circle having an arc that substantially matches the shape of the curve of the boundary portion. The numerical value shown in the circle is the diameter of the circle (unit: arbitrary unit).

Comparing Figs. 3 and 4, the shape of the boundary portion of the wafer 2 (Fig. 4) is gentler than the shape of the boundary portion of the wafer 1. Comparing the size of the circles of the wafer 1 and the wafer 2, the diameter of the circle obtained for the wafer 2 (hereinafter referred to as "D2") is greater than the diameter of the circle obtained for the wafer 1 (hereinafter referred to as "D1 "). As described above, the size of the circle obtained by the evaluation method for acquiring the reference value and the shape of the boundary portion are correlated.

The magnitude relationship between the widths W1 and W2 obtained for the wafer 1 and the wafer 2 in 1. hereinabove is such that the width of the wafer 2 is larger, that is, "W1 < W2", and the magnitude relationship of D1 and D2 obtained as reference values for the wafer 1 and the wafer 2 is also such that the diameter of the wafer 2 is larger, that is, "D1 < D2", and correspondence with the results obtained in 1. hereinabove can be confirmed.

### 3. Confirmation of Correlation between Evaluation Results and Reference Values

A differential interference image was acquired at the 3 o'clock position in the same manner as in 1. hereinabove for a plurality of semiconductor wafers that differed in polishing conditions and chamfering conditions on the wafer surface (silicon single crystal wafers (polished wafers) with a diameter of 300 mm and a (100) surface, with a notch), and the width of the white band between the gray band corresponding to the main surface and the black band corresponding to the chamfered surface was obtained in the acquired differential interference image.

For each of the plurality of semiconductor wafers, the reference value (diameter of the circle) was obtained in the same manner as in 2. hereinabove.

Fig. 5 shows a graph in which the width of the white band obtained for each semiconductor wafer as described hereinabove is plotted against the reference value. Fig. 5 also shows an approximate straight line obtained by the least squares method. In the approximate straight line, the square R² of the correlation coefficient is more than 0.90, indicating a strong correlation.

From the above results, it can be confirmed that the width W of the white band obtained by the above evaluation method can be an index for evaluating the shape of the boundary portion. With the evaluation based on the numerical value of the width of the white band, for example, by determining a threshold value (value of W) that can be determined as belonging to a non-defective product from past experience, the non-defective product can be easily determined.

The width W of the white band obtained as described above can be used for pre-shipment inspection as described above, can be used for sampling inspection from a lot, and can also be used for determining the actual manufacturing condition of semiconductor wafers.

### [Industrial Applicability]

The present invention is useful in the field of manufacturing various semiconductor wafers such as silicon wafers.

## Claims

1. A semiconductor wafer evaluation method comprising:
acquiring a differential interference image at an evaluation position on an outer peripheral portion of a semiconductor wafer to be evaluated with a reflection type differential interference microscope that is set so that a main surface of the semiconductor wafer is imaged as a gray band and a chamfered surface thereof is imaged as a black band, the differential interference image comprising the gray band and the black band, and further comprising a white band between the gray band and the black band; and **characterised by**
evaluating a shape of a boundary portion between the main surface of the semiconductor wafer and the chamfered surface adjacent to the main surface at the evaluation position by using a width W of the white band as an indicator.

2. A semiconductor wafer manufacturing method comprising:
manufacturing a candidate semiconductor wafer to be shipped as a product,
evaluating the candidate semiconductor wafer by the semiconductor wafer evaluation method according to claim 1; and
subjecting a semiconductor wafer, which has been determined to be a non-defective product as a result of the evaluation, to preparation for shipment as a product semiconductor wafer.

3. A semiconductor wafer manufacturing method comprising:
manufacturing a semiconductor wafer lot comprising a plurality of semiconductor wafers;
extracting at least one semiconductor wafer from the semiconductor wafer lot;
evaluating the extracted semiconductor wafer by the semiconductor wafer evaluation method according to claim 1; and
subjecting a semiconductor wafer of the same semiconductor wafer lot as the semiconductor wafer, which has been determined to be a non-defective product as a result of the evaluation, to preparation for shipment as a product semiconductor wafer.

4. A semiconductor wafer manufacturing method comprising:
manufacturing a semiconductor wafer to be evaluated under a test manufacturing condition;
evaluating the manufactured semiconductor wafer to be evaluated by the semiconductor wafer evaluation method according to claim 1;
determining a manufacturing condition, obtained by modifying the test manufacturing condition on the basis of a result of the evaluation, as an actual manufacturing condition, or determining the test manufacturing condition as the actual manufacturing condition; and
manufacturing a semiconductor wafer under the determined actual manufacturing condition.

5. The semiconductor wafer manufacturing method according to claim 4,
wherein the modified manufacturing condition is at least one of a polishing treatment condition and a chamfering processing condition of a semiconductor wafer surface.

## Patentansprüche

1. Halbleiterwafer-Bewertungsverfahren, umfassend:
Aufnehmen eines Differential-Interferenz-Bildes an einer Bewertungsposition an einem äußeren Randbereich eines zu bewertenden Halbleiterwafers mit einem Differential-Interferenz-Mikroskop vom Reflexionstyp, welches so eingestellt ist, dass eine Hauptoberfläche des Halbleiterwafers als graues Band abgebildet wird und eine angeschrägte Oberfläche davon als schwarzes Band abgebildet wird, wobei das Differential-Interferenz-Bild das graue Band und das schwarze Band umfasst und ferner ein weißes Band zwischen dem grauen Band und dem schwarzen Band umfasst; und **gekennzeichnet ist durch**
Bewerten einer Form eines Grenzbereichs zwischen der Hauptoberfläche des Halbleiterwafers und der angeschrägten Oberfläche, welche an der Bewertungsposition an die Hauptoberfläche angrenzt, unter Verwendung einer Breite W des weißen Bandes als Indikator.

2. Halbleiterwafer-Herstellungsverfahren, umfassend:
Herstellen eines Kandidaten-Halbleiterwafers, der als Produkt ausgeliefert werden soll,
Bewerten des Kandidaten-Halbleiterwafers durch das Halbleiterwafer-Bewertungsverfahren nach Anspruch 1; und
Unterziehen eines Halbleiterwafers, welcher als Ergebnis der Bewertung als nicht-mangelhaftes Produkt bestimmt wurde, der Vorbereitung für die Auslieferung als Produkt-Halbleiterwafer.

3. Halbleiterwafer-Herstellungsverfahren, umfassend:
Herstellen einer Halbleiterwafer-Charge, umfassend eine Vielzahl von Halbleiterwafern;
Entnehmen wenigstens eines Halbleiterwafers aus der Halbleiterwafer-Charge;
Bewerten des entnommenen Halbleiterwafers durch das Halbleiterwafer-Bewertungsverfahren nach Anspruch 1; und
Unterziehen eines Halbleiterwafers derselben Halbleiterwafer-Charge wie der des Halbleiterwafers, der als Ergebnis der Bewertung als nicht-mangelhaftes Produkt bestimmt wurde, der Vorbereitung zur Auslieferung als Produkt-Halbleiterwafer.

4. Halbleiterwafer-Herstellungsverfahren, umfassend:
Herstellen eines zu bewertenden Halbleiterwafers unter einer Test-Herstellungsbedingung;
Bewerten des hergestellten und zu bewertenden Halbleiterwafers durch das Halbleiterwafer-Bewertungsverfahren nach Anspruch 1;
Festlegen einer Herstellungsbedingung, erhalten durch Modifizieren der Test-Herstellungsbedingung auf Basis eines Ergebnisses der Bewertung, als tatsächliche Herstellungsbedingung, oder Festlegen der Test-Herstellungsbedingung als tatsächliche Herstellungsbedingung; und
Herstellen eines Halbleiterwafers unter der festgelegten tatsächlichen Herstellungsbedingung.

5. Halbleiterwafer-Herstellungsverfahren nach Anspruch 4,
wobei die modifizierte Herstellungsbedingung wenigstens eine ist von einer Bedingung für eine Polier-Behandlung und einer Bedingung für eine anschrägenden Bearbeitung einer Halbleiterwafer-Oberfläche.

## Revendications

1. Procédé d'évaluation de tranche de semi-conducteur comprenant :
une acquisition d'une image interférentielle différentielle à une position d'évaluation sur une partie périphérique extérieure d'une tranche de semi-conducteur devant être évaluée avec un microscope interférentiel différentiel du type à réflexion qui est réglé de sorte qu'une surface principale de la tranche de semi-conducteur soit imagée comme une bande grise et une surface chanfreinée de celle-ci soit imagée comme une bande noire, et l'image interférentielle différentielle comprenant la bande grise et la bande noire, et comprenant en outre une bande blanche entre la bande grise et la bande noire ; et **caractérisé par**
une évaluation d'une forme d'une partie limite entre la surface principale de la tranche de semi-conducteur et la surface chanfreinée adjacente à la surface principale à la position d'évaluation en utilisant une largeur W de la bande blanche comme indicateur.

2. Procédé de fabrication de tranche de semi-conducteur comprenant :
une fabrication d'une tranche de semi-conducteur candidate devant être expédiée en tant que produit,
une évaluation de la tranche de semi-conducteur candidate par le procédé d'évaluation de tranche de semi-conducteur selon la revendication 1; et
une soumission d'une tranche de semi-conducteur, qui a été déterminée comme étant un produit non défectueux suite à l'évaluation, à une préparation pour une expédition en tant que produit de tranche de semi-conducteur.

3. Procédé de fabrication de tranche de semi-conducteur comprenant :
une fabrication d'un lot de tranches de semi-conducteur comprenant une pluralité de tranches de semi-conducteur ;
une extraction d'au moins une tranche de semi-conducteur du lot de tranches de semi-conducteur ;
une évaluation de la tranche de semi-conducteur extraite par le procédé d'évaluation de tranche de semi-conducteur selon la revendication 1 ; et
une soumission d'une tranche de semi-conducteur du même lot de tranches de semi-conducteur que la tranche de semi-conducteur, qui a été déterminée comme étant un produit non défectueux suite à l'évaluation, à une préparation pour une expédition en tant que produit de tranche de semi-conducteur.

4. Procédé de fabrication de tranche de semi-conducteur comprenant :
une fabrication d'une tranche de semi-conducteur devant être évaluée dans une condition de fabrication test ;
une évaluation de la tranche de semi-conducteur fabriquée devant être évaluée par le procédé d'évaluation de tranche de semi-conducteur selon la revendication 1 ;
une détermination d'une condition de fabrication, obtenue en modifiant la condition de fabrication test sur la base d'un résultat de l'évaluation, comme étant une condition de fabrication réelle, ou une détermination de la condition de fabrication test comme étant la condition de fabrication réelle ; et
une fabrication d'une tranche de semi-conducteur dans la condition de fabrication réelle déterminée.

5. Procédé de fabrication de tranche de semi-conducteur selon la revendication 4,
dans lequel la condition de fabrication modifiée est au moins une d'une condition de traitement de polissage et une condition de traitement de chanfreinage d'une surface de tranche de semi-conducteur.
